Europäisches Patentamt

European Patent Office

Office européen des brevets

(19)

(11) EP 0 884 775 A1

(12) **EUROPEAN PATENT APPLICATION**

(43) Date of publication:
   **16.12.1998 Bulletin 1998/51**

(51) Int Cl.⁶: **H01L 21/78**, H01L 21/48, H01F 41/04, H01F 27/29

(21) Application number: **98401397.9**

(22) Date of filing: **10.06.1998**

(84) Designated Contracting States:
   **AT BE CH CY DE DK ES FI FR GB GR IE IT LI LU MC NL PT SE**
   Designated Extension States:
   **AL LT LV MK RO SI**

(30) Priority: **10.06.1997 JP 169520/97**

(71) Applicant: **MURATA MANUFACTURING CO., LTD.**
   **Nagaokakyo-shi Kyoto-fu 226 (JP)**

(72) Inventors:
   • **Matsuda, Katsuji, c/o Murata Manufac. Co., Ltd.**
      **Nagaokakyo-shi, Kyoto-fu (JP)**

   • **Uchiyama, Kazuyoshi,**
      **c/o Murata Manufac. Co., Ltd.**
      **Nagaokakyo-shi, Kyoto-fu (JP)**
   • **Kawaguchi, Masahiko,**
      **c/o Murata Manufac. Co., Ltd.**
      **Nagaokakyo-shi, Kyoto-fu (JP)**
   • **Misaki, Katsuhiro, c/o Murata Manufac. Co., Ltd.**
      **Nagaokakyo-shi, Kyoto-fu (JP)**
   • **Iida, Naoki, c/o Murata Manufacturing Co., Ltd.**
      **Nagaokakyo-shi, Kyoto-fu (JP)**

(74) Representative: **Joly, Jean-Jacques et al**
   **Cabinet Beau de Loménie**
   **158, rue de l'Université**
   **75340 Paris Cédex 07 (FR)**

(54) **Electronic component and manufacturing method therefor**

(57)    The present invention provides a method of manufacturing an electronic part capable of ensuring a wide area which can be used for forming elements on the surface of a unit substrate (1), and effectively producing an element part having desired performance. In the method, at least a portion of the unit substrate (1) is cut by using a blade (11) having a shape in which a portion thereof butted against the boundary (1c) between the electrode arrangement surface (1a) and the cut end surface (1b) of the unit substrate (1) or a portion which becomes the boundary (1c) is inclined at a predetermined angle to form an inclined surface (4) in the boundary (1c) or the portion which becomes the boundary (1c) and expose a part of an electrode (2, 2a) from the inclined surface (4).

FIG. 2

# Description

## BACKGROUND OF THE INVENTION

### 1. Field of the Invention

The present invention relates to a method of manufacturing an electronic part, and particularly to a method of manufacturing an electronic part comprising the step of cutting, along predetermined cutting lines, a unit substrate (parent substrate) having an electrode arrangement surface coated with a coating material to obtain an electronic part device with an electrode exposed from the cut end surface.

### 2. Description of the Related Art

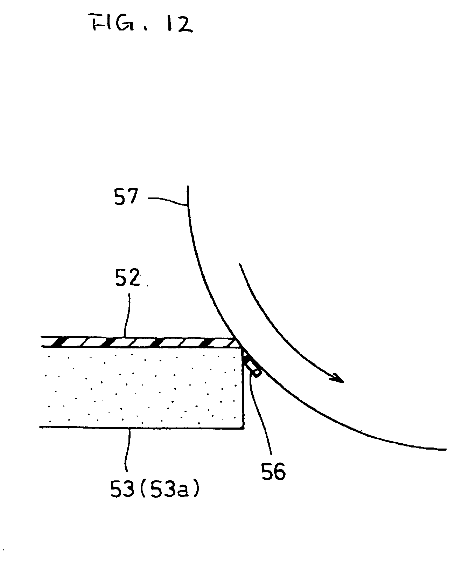

A chip type coil part comprising a thin film coil pattern (conductor pattern) disposed on the surface of a substrate is manufactured through the step of cutting, at predetermined positions, a unit substrate 53 comprising a plurality of thin film coil patterns 51 disposed thereon and having a surface coated with an insulating protective film (coating material) 52 to obtain respective elements 54, for example, as shown in Fig. 9.

As the insulating protective film 52, for example, a resin material such as polyimide or the like is generally used from the viewpoints of surface smoothness, insulation quality, heat resistance, and adaptability for fine processing accompanying miniaturisation of a chip.

As a method of cutting the unit substrate 53 at the predetermined positions into the respective elements 54, a breaking method using a scriber is known. However, this method is a cutting method utilising a cleavage function, and thus coating of the insulating protective film 52 on scribing lines makes cutting impossible, and requires cutting margins 55 (Fig. 9) to be provided around the insulating protective film 52.

In a chip type electronic part requiring to be miniaturised, particularly a chip type coil part having a conductor pattern such as a thin film coil pattern provided on the surface of a substrate, in order to maintain and improve performance, how to ensure a large area permitting the formation of the conductor pattern is important. However, the above scribe breaking technique for cutting the unit substrate has the problem of causing difficulties in ensuring an area permitting the formation of the conductor pattern, and thus making it impossible to sufficiently comply with the requirement for miniaturisation.

As another method of cutting the unit substrate at the predetermined positions into the respective elements, a dicing method is widely used in which the unit substrate is cut by using a dicing blade. This dicing method has excellent processing accuracy and is capable of cutting the insulating protective film 52 at the same time, thereby eliminating the need for the cutting margins. It is thus possible to form the insulating protective film 52 over the entire surface of the unit substrate, as shown in Fig. 10. The dicing method thus has the advantage that the conductor pattern 51 can be formed up to the periphery of a chip, and a wide area can be used for forming elements, as compared with the scribe breaking method.

Recently, from the viewpoint of utilisation of the maximum area of the substrate surface, the insulating protective film has been formed over the substantially whole area of the substrate, as shown in Fig. 10, and a connecting electrode 58 connected to an external terminal has been arranged at the end of each of the elements 54 and exposed from the cut end surface by cutting (dice cutting) using a dicing blade so as to be connected to an external electrode.

However, a chip type coil part in which the conductor pattern such as the thin film coil pattern is disposed on the surface of the substrate has recently been required to have characteristics for radio frequencies, and thus it has been essential to decrease the dielectric constant of the material of the substrate. Therefore, as the material for the substrate, low-dielectric-constant materials such as glass, glass ceramics, composite mica ceramics, ferrite, and the like have been used. These low-dielectric-constant materials have the problem of easily producing chipping, cracking or peeling in the substrate below the connecting electrode in the cut plane due to cutting impact, and thus causing deterioration in reliability due to poor connection with the external electrode or open failure due to peeling between the substrate and the connecting electrode. Figs. 11A and 11B are schematic drawings each showing a state wherein chipping C and peeling D occur when the unit substrate 53 with the surface having the conductor pattern 51 (the connecting electrode 58) disposed thereon and covered with the insulating protecting film 52 is cut by dicing.

## SUMMARY OF THE INVENTION

The present invention has been achieved for solving the above problems, and an object of the present invention is to provide a method of manufacturing an electronic part capable of ensuring a wide area which can be used for forming elements on the surface of a unit substrate, and efficiently manufacturing an electronic part having desired performance without deteriorating connection reliability.

In order to achieve the object, in accordance with one aspect of the present invention, there is provided a method of manufacturing an electronic part in which a unit substrate (parent substrate) having an electrode arrangement surface covered with a coating material is cut along predetermined cutting lines to obtain electronic part elements in each of which an electrode is exposed from the cut end surface, the method comprising the step of:

cutting at least a portion of the unit substrate by using a blade having a shape in which a portion butted against the boundary (shoulder) between the electrode arrangement surface and the cut end surface of the unit substrate, or a portion which becomes the boundary (shoulder) is inclined at a predetermined angle to form an inclined surface in the boundary (shoulder) or the portion which becomes the boundary (shoulder) and expose a portion of the electrode from the inclined surface.

In this method, at least a portion of the unit substrate is cut by using a blade having a shape in which a portion butted against the boundary (shoulder) between the electrode arrangement surface and the cut end surface of the unit substrate, or a portion which becomes the boundary (shoulder) is inclined at a predetermined angle to form an inclined surface in the boundary (shoulder) or the portion which becomes the boundary (shoulder) and expose a portion of the electrode from the inclined surface. Therefore, it is possible to increase the exposure area of the electrode, and improve electrical connectability with an external terminal and Q of inductance.

In the present invention, "cutting the unit substrate along cutting lines" means a wide idea including a case in which the unit substrate is cut by using a dicing blade, a case in which the unit substrate is cut by scribe breaking using a scriber, and the like.

In the method of manufacturing an electronic part of the present invention, as a material for forming the blade, for example, a material comprising a metal binder and diamond particles having a grain size of #200 to #1200, preferably #600 to #1000 can be used.

In accordance with another aspect of the present invention, there is provided a method of manufacturing an electronic part in which a unit substrate (parent substrate) having an electrode arrangement surface covered with a coating material is cut along predetermined cutting lines to obtain electronic part elements in each of which an electrode is exposed from the cut end surface, the method comprising the steps of:

forming a groove along each of the predetermined cutting lines by using a blade having a shape in which a portion butted against a portion which becomes the boundary (shoulder) between the electrode arrangement surface and the cut end surface of the unit substrate is inclined at a predetermined angle to form an inclined surface in the portion which becomes the boundary between the electrode arrangement surface and the cut end surface of the unit substrate and expose a portion of the electrode from the inclined surface before cutting the unit substrate along the cutting lines; and then cutting the unit substrate along the predetermined cutting lines to leave at least the portion of the inclined surface where the electrode is exposed.

In this method, before the unit substrate is cut along the cutting lines, the groove is formed along each of the cutting lines by cutting the portion which becomes the boundary (shoulder) between the electrode arrangement surface and the cut end surface using a blade having a shape in which a portion thereof butted against that portion is inclined at the predetermined angle to form an inclined surface in the portion which becomes the boundary (shoulder) of the unit substrate and expose a portion of the electrode from the inclined surface, and then the unit substrate is cut along the cutting lines to leave at least the portion of the inclined surface where the electrode is exposed. Therefore, it is possible to increase the area where the electrode is exposed, and improve the electrical connectability with an external terminal and Q of inductance, as compared with a case (conventional method) in which no inclined surface is formed in the boundary (shoulder).

After the grooves are formed, the unit substrate is cut along the substantially center of each of the grooves by using, for example, a dicing blade having a thickness smaller than the width of the grooves by a predetermined amount to leave the portion of the inclined surface where the electrode is exposed, to obtain respective electronic part elements.

In accordance with a still another aspect of the present invention, there is provided a method of manufacturing an electronic part in which a unit substrate (parent substrate) having an electrode arrangement surface covered with a coating material is cut along predetermined cutting lines to obtain electronic part elements in each of which an electrode is exposed from the cut end surface, the method comprising the steps of:

cutting the unit substrate along the predetermined cutting lines; and forming an inclined surface in the boundary (shoulder) between the electrode arrangement surface and the cut end surface of the unit substrate by using a blade having a shape in which a portion thereof butted against the boundary (shoulder) of the unit substrate is inclined at a predetermined angle to expose a portion of the electrode from the inclined surface.

In this method, after the unit substrate is cut along the cutting lines, an inclined surface is formed in the boundary (shoulder) between the electrode arrangement surface and the cut end surface of the unit substrate by using a blade having a shape in which a portion thereof butted against the boundary (shoulder) of the unit substrate is inclined to expose a portion of the electrode from the inclined surface. Therefore, it is possible to securely increase the area where the electrode is exposed, and improve the electrical connectability with an external terminal, and Q of inductance, as compared with a case (conventional method) in which no inclined surface is formed in the boundary (shoulder).

The method of manufacturing an electronic part of the present invention uses a dicing blade for cutting the unit substrate.

Since the unit substrate is cut by using a dicing blade (i.e., dice cutting), unlike in the case of scribe cutting, it is unnecessary to provide cutting margins, thereby making it possible to utilise the maximum area of the substrate surface, and making the present invention more effective.

Also the method of manufacturing an electronic part of the present invention uses a dicing blade having a substantially disk shape comprising a thin portion having a small thickness and formed in the peripheral portion outside a predetermined position in the radial direction, a thick portion having a larger thickness than the thin portion and formed nearer the central side than the thin portion, and an inclined portion formed in the boundary between the thin potion and the thick portion so that the unit substrate is cut by the thin portion of the blade, and the boundary (shoulder) of the unit substrate or a portion which becomes the boundary (shoulder) thereof is cut by the inclined portion of the blade to form an inclined surface in the boundary (shoulder) of the unit substrate.

By using the dicing blade comprising the thin portion, the thick portion and the inclined portion formed in the boundary between both portions, it is possible to cut the unit substrate by the thin portion, and cut the boundary (shoulder) between the electrode arrangement surface and the cut end surface of the unit substrate by the inclined portion of the blade to securely form an inclined surface in the boundary (shoulder) of the unit substrate. Namely, the use of the above blade makes it possible to cut the unit substrate and, at the same time, form the inclined surface in the boundary (shoulder) only by one stroke of operation, thereby improving productivity.

The positional relation between the thin portion, the thick portion and the inclined portion can be adjusted to cut a portion of the unit substrate which becomes the boundary (shoulder) between the electrode arrangement surface and the cut end surface by the inclined portion of the blade to form an inclined surface before completely cutting substrate by the thin portion of the blade, to cut the boundary (shoulder) of the unit substrate by the inclined portion of the blade after completely cutting the unit substrate by the thin portion of the blade, or cut the unit substrate and form the inclined surface at substantially the same time.

In accordance with a further aspect of the present invention, there is provided a method of manufacturing an electronic part in which a unit substrate (parent substrate) having an electrode arrangement surface covered with a coating material is cut along predetermined cutting lines to obtain electronic part elements in each of which an electrode is exposed from the cut end surface, the method comprising the steps of:

forming a groove in the surface of the unit substrate along each of the predetermined cutting lines by using a blade having a shape in which the central portion of the peripheral surface in the depthwise direction projects so that the projecting central tip functions as a breaking groove forming portion for forming breaking grooves in the unit substrate, for breaking the unit substrate, and an adjacent inclined portion adjacent to the projecting central tip functions as an inclined surface forming portion for cutting a portion of the unit substrate which becomes the boundary (shoulder) between the electrode arrangement surface and the cut end surface to form an inclined surface in the portion which becomes the boundary (shoulder), and in which the angle $\theta 1$ formed by two surfaces of the central tip is smaller than the angle $\theta 2$ formed by two surfaces of the inclined surface forming portion, to form the breaking grooves in the surface of the unit substrate and, at the same time, form the inclined surface in the portion which becomes the boundary (shoulder) between the electrode arrangement surface and the cut end surface; and then breaking the unit substrate along the breaking grooves to obtain an element having an electrode partially exposed from the inclined surface.

In this method, the groove is formed in the surface of the unit substrate along each of the cutting lines by using the blade comprising the projecting central tip functioning as the breaking groove forming portion for forming the breaking grooves in the unit substrate, and the inclined portion adjacent to the central tip functioning as the inclined surface forming portion for forming the inclined surface by cutting the boundary (shoulder) of the unit substrate, the angle $\theta 1$ formed by two surfaces of the central tip being smaller than the angle $\theta 2$ formed by two surfaces of the inclined surface forming portion. Therefore, it is possible to easily securely form the breaking grooves and the inclined surfaces in the surface of the unit substrate, and securely obtain each element having an electrode exposed from the inclined surfaces by breaking the unit substrate along the breaking grooves.

In forming the grooves by using the blade, the depth (the vertical distance between the surface of the unit substrate and the bottom of the groove) of each of the grooves is preferably in the range of 10 to 30% of the thickness of the unit substrate. This is because with a groove depth of less than 10% of the thickness of the unit substrate, the unit substrate cannot be easily broken along the grooves, thereby causing oblique breaking, and with a groove depth of over 10% of the thickness of the unit substrate, cracks unnecessary for the later steps undesirably occur.

The method of manufacturing an electronic part of the present invention uses a blade comprising an inner member made of a material suitable for cutting the unit substrate and having a tip projecting to contact the unit substrate earlier than other portions, and outer members made of a material suitable for cutting the coating material and holding the inner member therebetween from the both sides thereof.

The blade comprises the two members including the inner member and the outer member which are made of materials suitable for cutting the unit substrate and the coating material, respectively. Therefore, it is possible to cut the unit substrate by the inner member while suppressing occurrence of chipping or the like, and cut the coating material such as an insulating protective film or the like by the outer members without leaving chips of the coating material, thereby making the present invention more effective.

In other words, in a conventional dicing technique, as shown in Fig. 10, the unit substrate 53 is cut along cutting lines A and B perpendicular to each other. However, in some cases, for example, the unit substrate is primarily cut along the cutting lines A, and then each of the stick-shaped unit substrates 53a is secondarily cut along the cutting lines B to obtain respective elements 54.

In such cases, in secondary cutting, a dicing blade contacts the end of the substrate (the end of each of the stick-shaped substrates 53a obtained by primary cutting). At this time, a dicing blade 57 first contacts the insulating protective film 52 to cut it at the end of each of the stick-shaped unit substrates 53a, as shown in Fig. 12. Since the insulating protective film 52 has flexibility and elongation as compared with the material which constitutes the substrate, and fine chipping easily occur at the end of each of the unit substrates 53a, chips of the insulating protective film 52 are generated at the end of the substrate due to elongation and retraction of the insulating protective film 52, and remain in each of the elements 54.

A product having remaining chips of the insulating protective film has problems of a poor appearance and occurrence of a disadvantage in a set product after packaging of a complete product.

However, as in the method of manufacturing an electronic part in accordance with the present invention, the blade comprising the two members including the inner member made of a material suitable for cutting the unit substrate, and the outer member made of a material suitable for cutting the coating material is used for efficiently preventing the remainder of chips of the coating material such as the insulating protective film or the like, and avoiding the occurrence of a poor appearance and a disadvantage in a set product after packaging.

Of the materials which constitute the blade, as the material suitable for cutting the unit substrate, for example, a material composed of diamond particles of #600 to #1000 and a metallic binder can be used. As the material suitable for cutting the coating material, for example, a material composed of diamond particles of #200 to #600 and a metallic binder can be used. However, the materials which constitute the blade are not limited to these materials, and various known materials can be used.

## BRIEF DESCRIPTION OF THE DRAWINGS

Fig. 1 is a drawing showing a principal portion of a unit substrate formed in a step of a method of manufacturing an electronic part in accordance with an embodiment of the present invention, in which Fig. 1A is a front sectional view, and Fig. IB is a sectional view taken along line B-B in Fig. 1A;

Fig. 2 is a drawing showing a state in which a groove is formed in a unit substrate in a step of a method of manufacturing an electronic part in accordance with an embodiment of the present invention;

Fig. 3 is a drawing showing a state in which a unit substrate having a groove formed therein is cut in a step of a method of manufacturing an electronic part in accordance with an embodiment of the present invention;

Fig. 4 is a perspective view showing an element obtained by cutting a unit substrate in a step of a method of manufacturing an electronic part in accordance with an embodiment of the present invention;

Fig. 5 is a drawing showing a modified example of the blade used in a method of manufacturing an electronic part in accordance with an embodiment of the present invention;

Fig. 6 is a drawing showing the structure of the blade used in a method of manufacturing an electronic part in accordance with another embodiment of the present invention;

Fig. 7 is a drawing showing the structure of the blade used in a method of manufacturing an electronic part in accordance with a further embodiment of the present invention;

Fig. 8 is a drawing showing the structure of the blade used in a method of manufacturing an electronic part in accordance with a still further embodiment of the present invention;

Fig. 9 is a drawing showing a unit substrate formed by a conventional method of manufacturing an electronic part;

Fig. 10 is a drawing showing a unit substrate formed by another conventional method of manufacturing an electronic part;

Figs. 11A and 11B are schematic drawings each showing a state where chipping and peeling occur in dice cutting of a unit substrate having a surface coated with an insulating protective film in which conductor patterns are arranged, in a conventional method of manufacturing an electronic part; and

Fig. 12 is a drawing showing a state where a unit substrate is cut in a step of a conventional method of manufacturing an electronic part.

## DESCRIPTION OF THE PREFERRED EMBODIMENT

The characteristics of the present invention will be described in further detail below with reference to embodiments.

First Embodiment

In this embodiment, description is made of manufacture of a chip type coil part having a structure in which a thin film coil pattern (conductor pattern) and a connecting electrode for connection with the outside are disposed on the surface of a substrate, and the surface having the thin film coil pattern and the connecting electrode disposed thereon is coated with an insulating protective film (coating material). The present invention can be applied to cases in which as a material for the substrate, various materials such as glass, glass ceramics, composite mica ceramics, ferrite and the like are used.

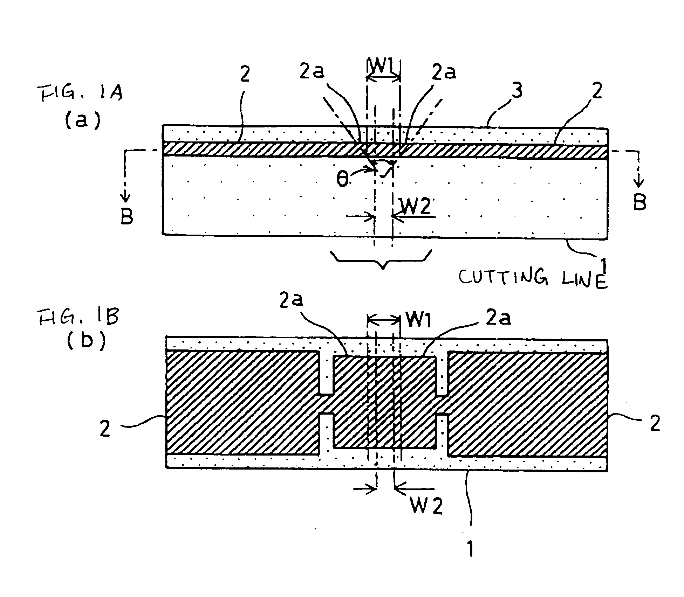

First, as shown in Figs. 1A and 1B, a thin film coil pattern (in a wide sense, an electrode) 2 including a connecting electrode 2a is formed, and an insulating protective film 3 for protecting the thin film coil pattern 2 is then formed on the surface of the unit substrate 1 in which the thin film coil pattern 2 is disposed.

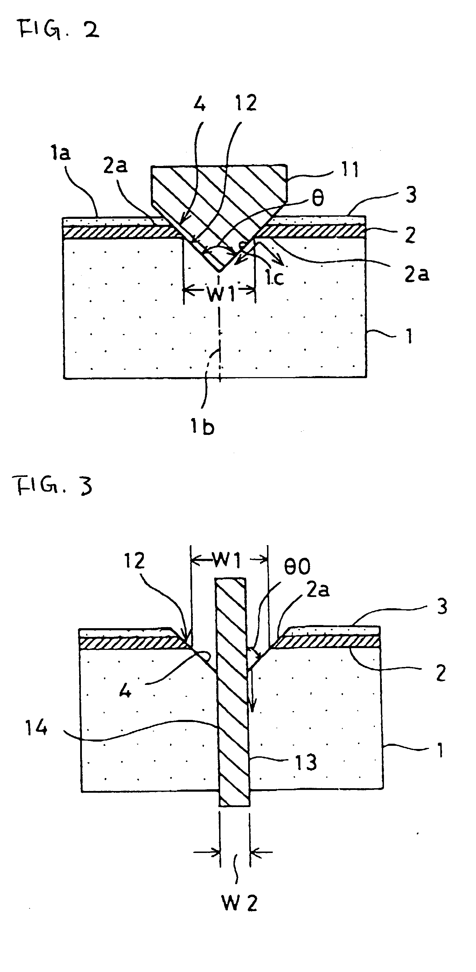

Then, V-shaped grooves 12 (Figs. 2 and 3) are formed in the surface of the unit substrate 1 as described below, and the unit substrate 1 is cut into respective elements.

In forming the groove 12, as shown in Fig. 2, the V-shaped groove 12 having a width W1 is formed in the surface of the unit substrate 1 by using a blade 11 having a shape in which the central portion of the peripheral surface in the thickness direction projects in an angular form. The width W1 represents the width of the groove formed in the substrate directly below the electrode (connecting electrode 2a).

The blade 11 is composed of a metallic binder and diamond particles. As the constituent material of the blade 11, for example, the metallic binder and diamond particles having a particle size of #200 to #1200, preferably #600 to #1000, can be used.

The angle $\theta$ formed by two surfaces of the tip of the blade 11 is adjusted to 75 to 120°. The reason for preferably setting the angle $\theta$ formed by two surfaces of the tip of the blade 11 to 75 to 120° is that with an excessively small angle $\theta$, the width (cutting width) of the groove 12 is stabilized, but the effect of relieving the impact on the substrate is insufficient, and with an excessively large angle $\theta$, the width (cutting width) of the groove 12 greatly varies with variations in the thickness of the unit substrate 1, thereby causing difficulties in stable control.

The unit substrate 1 having the groove 12 formed as described above is then cut along the center of the V-shaped groove 12 by using a dicing blade 13 having a width (thickness) W2 smaller than the width W1 of the groove 12, as shown in Fig. 3. The width (thickness) W2 of the dicing blade 13 is set to a value which allows the inclined surface of the substrate below the connecting electrode 2a to be left to some extent.

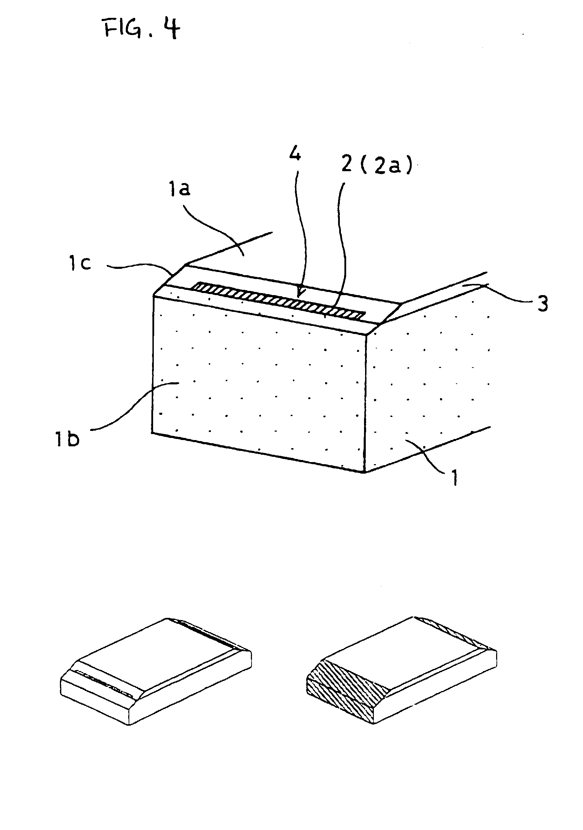

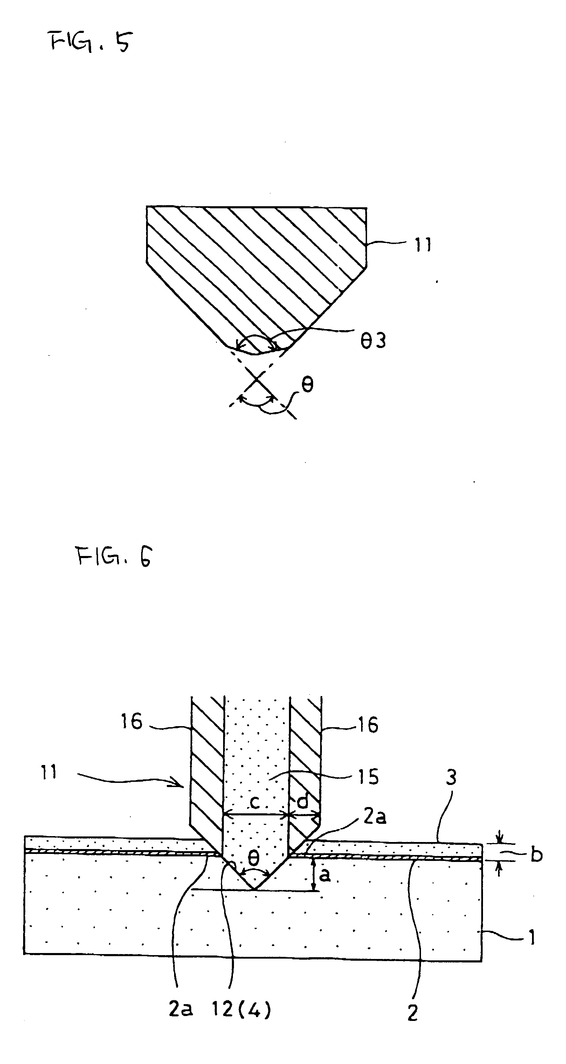

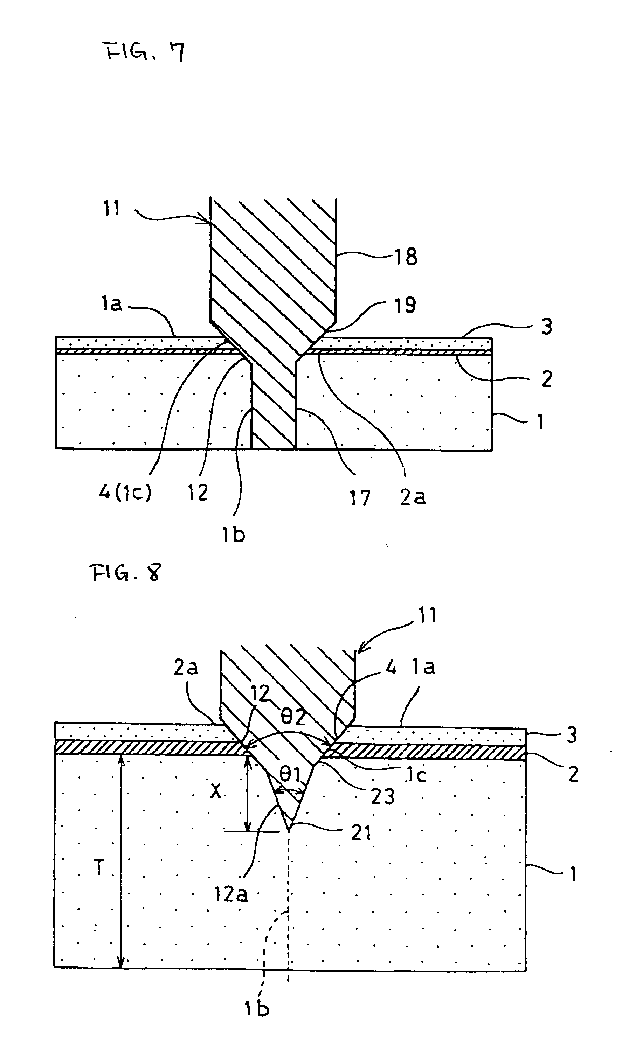

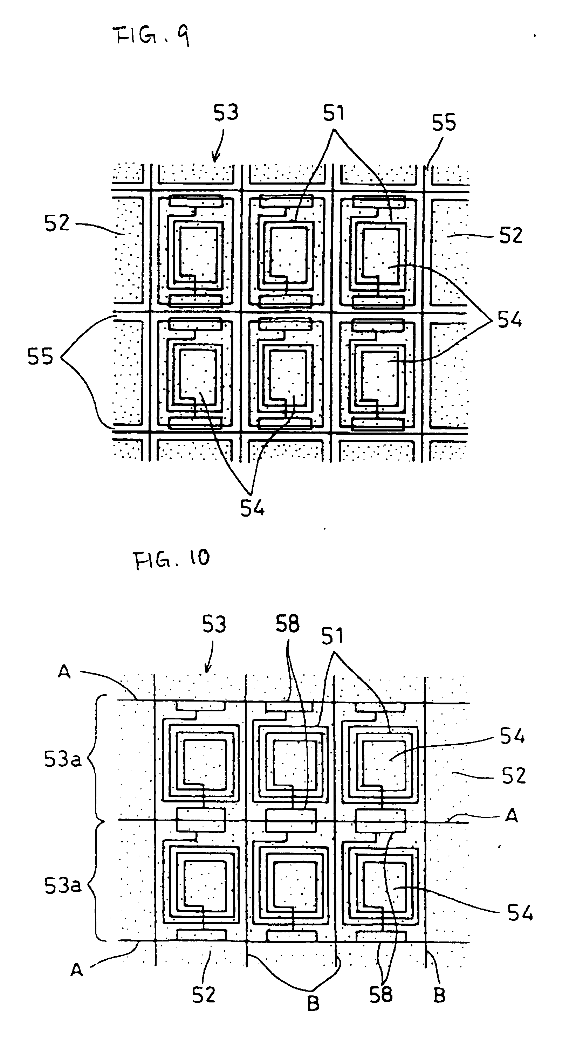

As a result, an element (chip type coil part element) is obtained in which the inclined surface 4 is formed in the boundary (shoulder) between the surface la in which the electrode 2 is disposed and the cut end surface (vertical cut surface) 1b of the unit substrate 1, and the connecting electrode 2a is exposed from the inclined surface 4, as shown in Fig. 4.

At either end of the element is formed an outer terminal electrode connected to the connecting electrode 2a by means such as a thin film forming method such as sputtering or the like, coating conductive paste, baking or the like to complete an electronic part.

In this embodiment, the unit substrate 1 is cut along the V-shaped groove 12 by using the dicing blade 13 having a width (thickness) W2 smaller than the width W1 of the groove 12. Therefore, it is possible to securely leave a portion of the inclined surface 4 in the boundary (shoulder) 1c where the electrode is exposed, and increase the exposure area of the electrode, as compared with a conventional case in which no inclined surface is formed in the boundary (shoulder). Namely, if the angle formed by the inclined surface 4 where the connecting electrode 2a is exposed and the vertical cut surface 1b is $\theta 0$ ($\theta/2$) (Fig. 3), the area of the surface where the connecting electrode 2a is exposed is enlarged 1/cos $\theta 0$ (> 1) times a conventional case without oblique processing.

As described above, oblique processing of the connecting electrode increases the exposed area, and causes smooth connection between the surface where the connecting electrode is exposed and the substrate material around it, thereby improving electrical connectability between the connecting electrode 2a and an external terminal and characteristics such as Q of inductance.

Since the blade 11 has a sharp tip for oblique cutting, the impact applied to the substrate directly below the connecting electrode is low during cutting, and the occurrence of chipping and cracking can be suppressed, as compared with a conventional case where the substrate is cut by using a dicing blade having a flat peripheral surface.

In oblique cutting, since the amount of cutting is small, and the cutting resistance is low, it is possible to cut the substrate by using a blade composed of smaller diamond particles, and thus improve the surface state (surface roughness) of the substrate near the connecting electrode 2a.

In this embodiment, since the unit substrate 1 is cut by using the dicing blade 13 after the groove 12 is formed, the substrate material directly below the connecting electrode 2a has previously obliquely been cut in the step of forming the groove 12, and thus the unit substrate 1 is not directly cut by the dicing blade 13. Also, since the dicing blade 13 used has the thickness W2 which allows the inclined surface of the substrate below the connecting electrode 2a to be left to some extent after cutting of the unit substrate 1, if chipping or cracking occurs, no chipping occurs in the substrate directly below the connecting electrode 2a, thereby causing high reliability.

Since the connecting electrode is exposed from the inclined surface, it is possible to form the external terminal electrode on upper and lower sides of an element by sputtering or the like which is capable of forming a precise pattern, and thus improve characteristics.

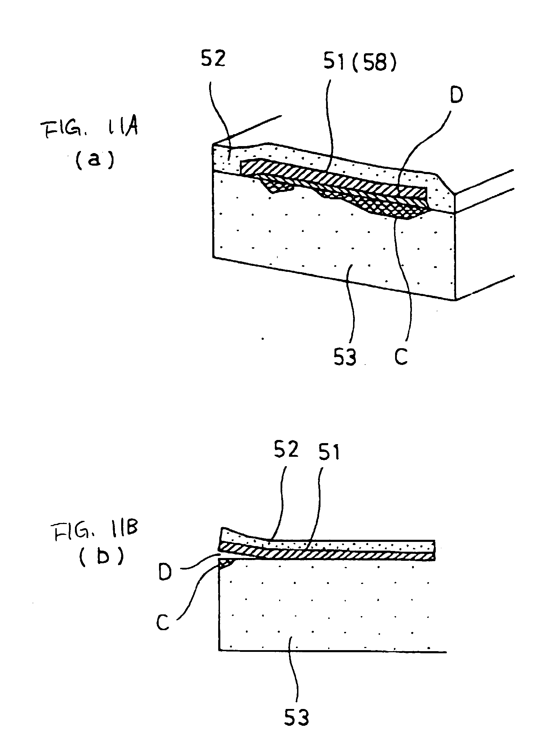

The shape and angle of the blade 11 are not particularly limited except the portion for forming the inclined surface 4 in the boundary (shoulder) of the unit substrate 1, and the angle $\theta 3$ of the tip may be larger than the angle $\theta$ of the portion for forming the inclined surface 4, as shown in Fig. 5.

## Second Embodiment

In this embodiment, the blade 11 used for forming the groove 12 in the unit substrate 1 has a structure in which an inner member 15 having a tip projecting to contact the insulating protective film 3 coating the surface of the unit substrate 1 earlier than other portions is held between outer members 16 from the both sides thereof, as shown in Fig. 6.

The inner member 15 and the outer members 16 are made of materials suitable for cutting the unit substrate 1 and the insulating protective film 3, respectively.

As each of the inner member 15 and the outer members 16, for example, a material comprising a metallic binder and diamond particles having a predetermined particle size can be used.

A material comprising diamond particles having a small particle size (for example, diamond particles of #600 to #1000) suitable for cutting the unit substrate 1 is preferably used for the inner member 15, and a material comprising diamond particles having a large particle size (for example, diamond particles of #200 to #600) suitable for cutting the insulating protective film 3 is preferably used for the outer members 16.

By using the blade 11 having the above structure, it is possible to cut the unit substrate 1 by the inner member 15 while suppressing the occurrence of chipping or the like, and efficiently cut the insulating protective film 3 by the outer members 16 while preventing the remainder of chips of the insulating protective film 3 to securely form the V-shaped grooves 12 in the surface of the unit substrate 1.

In the second embodiment, besides the above-mentioned effect, the same effect as that obtained in the first embodiment can be obtained.

In the structure of the blade 11, if the depth of the groove 12 is $\underline{a}$, the total thickness of the insulating protective film 3 and the electrode (connecting electrode) 2a is $\underline{b}$, the angle formed by two surfaces of the tip of the blade 11 is $\theta$, the thickness of the inner member 15 is $\underline{c}$, and the thickness of the outer member 16 is d, the thickness c of the inner member 15 is given by the following equation:

$$c = 2a \tan (\theta/2);$$

and the thickness $\underline{d}$ of the outer member 16 is given by the following equation:

$$d > b \tan (\theta/2).$$

After the groove 12 has been formed, for example, like in the first embodiment, the unit substrate 1 can be divided into respective elements by dice cutting.

## Third Embodiment

In this embodiment, as the blade 11 for forming the groove 12 in the unit substrate 1 and cutting the unit substrate 1, a substantially disk-shaped blade (dicing blade) 11 is used, which comprises a thin portion 17 having a small thickness and formed in the outer periphery outside the predetermined position in the radial direction, a thick portion 18 having a large thickness and formed nearer the central side than the thin portion 17, and an inclined portion 19 formed in the boundary between the thin portion 17 and the thick portion 18, as shown in Fig. 7. As the constituent material of the blade 11, for example, a material comprising a metallic binder and diamond particles having a particle size of #200 to #1200, preferably #600 to #1000, can be used.

By using the blade 11 comprising the thin portion 17, the thick portion 18 and the inclined portion 19 formed in the boundary therebetween, it is possible to securely cut the unit substrate 1 by the thin portion 17, and cut the boundary (shoulder) 1c between the surface la where the electrode 2 is disposed and the cut end surface 1b of the unit substrate 1 by the inclined portion 19 to securely form the inclined surface 4 in the boundary (shoulder) 1c, thereby making the present invention more effective. Namely, by using the blade 11, it is possible to cut the unit substrate and, at the same time, form the inclined surface in the boundary (shoulder) by one-stroke operation of a type of blade, and improve productivity.

In the third embodiment, besides the above effect, the same effect as that obtained in the first embodiment can be obtained.

The positional relation between the thin portion 17, the thick portion 18 and the inclined portion 19 can be controlled to form the inclined surface 4 by cutting a portion of the unit substrate 1 which becomes the boundary (shoulder) 1c by the inclined portion 19 before completely cutting the unit substrate 1 by the thin portion 17, form the inclined surface 4 by cutting the boundary (shoulder) 1c of the unit substrate 1 by the inclined portion 19 after completely cutting the unit substrate 1 by the thin portion 17, or cut the unit substrate 1 and form the inclined surface 4 at the same time.

## Fourth Embodiment

In this embodiment, the blade 11 used has a shape in which the tip 21 at the center of the peripheral surface in the thickness direction projects so that the projecting central tip 21 functions as a break groove forming portion for forming a break groove 12a in the unit substrate 1, for breaking the unit substrate 1, and the adjacent inclined portion 23 adjacent to the central tip 21 functions as an inclined surface forming portion for cutting a portion of the unit substrate 1 which becomes the boundary (shoulder) lc between the surface la where the electrode 2 is disposed and the cut end surface 1b to form the inclined surface 4 in the portion which becomes the boundary (shoulder) 1c, and in which the angle θ1 formed by two surfaces of the central tip 21 is smaller than the angle θ2 formed by two surfaces of the inclined surface forming portion (adjacent inclined portion) 23. As the constituent material of the blade 11, for example, a material comprising a metallic binder and diamond particles having a particle size of #200 to #1200, preferably #600 to #1000, can be used.

In the blade 11, the angle θ1 formed by two surfaces of the central tip 21 is preferably in the range of 60 to 90°, and the angle θ2 formed by two surfaces of the inclined surface forming portion (adjacent inclined portion) 23 is preferably in the range of 75 to 120°. The reason why the angle θ1 is preferably in the range of 60 to 90° is that with θ1 of less than 60°, wear of the blade 11 is significantly increased, and stable cutting is difficult, and with θ1 of over 90°, the force applied for breaking is not concentrated on the center, and thus stable division cannot be performed. The reason why the angle θ2 formed by two surfaces of the inclined surface forming portion (adjacent inclined portion) 23 is preferably in the range of 75 to 120° is that with θ2 of less than 75°, the width (cut width) of the groove 12 is stabilized, but the effect of relieving the impact on the unit substrate 1 is insufficient, and with θ2 of over 120°, the width (cut width) of the groove 12 significantly varies with variations in the thickness of the unit substrate 1, and thus stable control of the width is difficult.

In forming the groove 12 by using the blade 11 of this embodiment, the depth X (Fig. 8) of the groove 12 is in the range of 10 to 30% of the thickness T of the unit substrate 1. This is because with a depth X of less than 10% of the thickness of the unit substrate 1, it is difficult to divide the unit substrate 1 along the groove 12, and oblique division occurs, and with a depth X of over 30% of the thickness of the unit substrate 1, cracks unnecessary for the later steps undesirably occur.

In forming the groove 12 in the surface of the unit substrate 1 along each of the predetermined cutting lines by using the blade 11, the break groove 12a and the inclined surface 4 can easily and securely be formed in the surface of the unit substrate 1. By breaking the unit substrate 1 along the break groove 12a, it is possible to easily obtain an element in which the electrode 2 (connecting electrode 2a) is partially exposed from the inclined surface 4. It is thus possible to increase the exposure area of the connecting electrode 2 to improve the electrical connectability with an external terminal and improve characteristics such as Q of inductance.

In the fourth embodiment, besides the above effect, the same effect as that obtained in the first embodiment can be obtained.

Although, in each of the above embodiments, a case in which a tip type coil part is manufactured is described as an example, the present invention can also be applied to not only the tip type coil part but also various electronic parts in which the surface is coated with a coating material such as an insulating protective film or the like.

Although, in each of the above embodiments, a case in which the insulating protective film is formed on only a side of the unit substrate has been described, the present invention can also be applied to cases in which the insulating protective film is formed on both sides of the unit substrate.

The present invention is not limited to the above embodiments with respect to other points, and various applications and modifications can be made in the scope of the gist of the invention.

As described above, the method of manufacturing an electronic part of the present invention comprises cutting at least a portion of a unit substrate by using a blade having a shape in which a portion butted against the boundary (shoulder) of the unit substrate between the electrode arrangement surface and the cut end surface, or a portion which becomes the boundary (shoulder) is inclined as the predetermined angle to form an inclined surface in the boundary (shoulder) or the portion which becomes the boundary (shoulder) and expose a portion of the electrode from the inclined surface. It is thus possible to increase the exposure area of the electrode to improve electrical connectability with an external terminal and improve characteristics such as Q of inductance, as compared with a case (conventional method) in which no inclined surface is formed in the boundary (shoulder).

The method of manufacturing an electronic part of the present invention may comprise cutting a portion of a unit substrate which becomes the boundary (shoulder) between the electrode arrangement surface and the cut end surface by using a blade having a shape in which a portion butted against the portion of the unit substrate which becomes the boundary (shoulder) is inclined at a predetermined angle before cutting the unit substrate along cutting lines to form a groove along each of the cutting lines, form an inclined surface in the portion of the unit substrate which becomes the boundary (shoulder) and expose a portion of an electrode from the inclined surface, and then cutting the unit substrate along the cutting lines to leave at least a portion of the inclined surface where the electrode is exposed. It is thus possible to increase the exposure area of the electrode, improve electrical connectability with an external terminal and improve characteristics such as Q of inductance, as compared with a case (conventional method) in which no inclined surface is formed in the boundary (shoulder).

Also the method of manufacturing an electronic part of the present invention may comprise cutting a unit substrate along cutting lines and then forming an inclined surface in the boundary (shoulder) of the unit substrate between the electrode arrangement surface and the cut end surface by using a blade having a shape in which a portion butted against the boundary (shoulder) between the electrode arrangement surface and the cut end surface is inclined, to expose a portion of an electrode from the inclined surface. It is thus possible to increase the exposure area of the electrode, improve electrical connectability with an external terminal and improve characteristics such as Q of inductance, as compared with a case (conventional method) in which no inclined surface is formed in the boundary (shoulder).

In the method of manufacturing an electronic part of the present invention, the use of a dicing blade for cutting the unit substrate permits the maximum utilisation of the surface of the substrate and can make the present invention more effective.

The method of manufacturing an electronic part of the present invention may use a dicing blade comprising a thin portion, a thick portion and an inclined portion formed in the boundary therebetween so that the unit substrate can be cut by the thin portion, and the boundary (shoulder) of the unit substrate between the electrode arrangement surface and the cut end surface can be cut by the inclined surface to securely form an inclined surface in the boundary (shoulder). Namely, the use of the blade permits cutting of the unit substrate and the formation of the inclined surface in the boundary (shoulder) at the same time by simply operating a type of blade for one stroke, thereby improving productivity.

Further, the method of manufacturing an electronic part of the present invention may comprise forming a groove in the surface of a unit substrate along each of predetermined cutting lines by using a blade comprising a projecting central tip functioning as a break groove forming portion for forming a break groove in the unit substrate, and an adjacent inclined portion adjacent to the central tip, which functions as an inclined surface forming portion for forming an inclined surface in the boundary (shoulder) of the unit substrate by cutting it, in which the angle $\theta 1$ formed by two surfaces of the central tip is smaller than the angle $\theta 2$ formed by two surfaces of the inclined surface forming portion. It is thus possible to effectively form the break groove and the inclined surface in the surface of the unit substrate, thereby improving productivity.

Further, the method of manufacturing an electronic part of the present invention may use a blade comprising two types of members including an inner member and an outer member, wherein the inner member is made of a material suitable for cutting a unit substrate, and the outer member is made of a material suitable for cutting a coating material. It is thus possible to cut the unit substrate by the inner member while suppressing the occurrence of chipping or the like, and cut a coating material such as an insulating protective film by the outer member without leaving chips of the coating material, thereby making the present invention more effective.

The present invention further relates to an electronic part comprising a rectangular element having an upper side, a lower side and four sides connecting to the upper and lower sides; a conductor pattern buried in the rectangular element; an external terminal electrode connected to an exposed portion of the conductor pattern which is exposed from at least one side of the rectangular element; and a chamfer inclined surface formed in the boundary between the upper side and each of the four sides of the rectangular element so that the conductor pattern is led out to the inclined surface, and the exposed portion of the conductor pattern is inclined along the inclined surface.

## Claims

1. A method of manufacturing an electronic part in which a unit substrate (1) having an electrode arrangement surface coated with a coating material (3) is cut along predetermined cutting lines to obtain an electronic part element having an electrode (2, 2a) exposed from the cut end surface, the method comprising the step of:

   cutting at least a portion of the unit substrate (1) by using a blade (11) having a shape in which a portion thereof butted against the boundary (lc) of the unit substrate (1) between the electrode arrangement surface (1a) and the cut end surface (1b) thereof or a portion which becomes the boundary (1c) is inclined at a predetermined angle to form an inclined surface (4) in the boundary (1c) or the portion which becomes the boundary (1c) and expose a portion of the electrode (2, 2a) from the inclined surface (4).

2. A method of manufacturing an electronic part in which a unit substrate (1) having an electrode arrangement surface coated with a coating material (3) is cut along predetermined cutting lines to obtain an electronic part element having an electrode (2, 2a) exposed from the cut end surface, the method comprising the steps of:

   forming a groove along each of the predetermined cutting lines by using a blade (11) having a shape in which a portion thereof butted against a portion of the unit substrate which becomes the boundary (1c) between the electrode arrangement surface (1a) and the cut end surface (1b) is inclined at a predetermined angle to form an inclined surface (4) in the portion of the unit substrate (1) which becomes the boundary (1c) between the electrode arrangement surface (la) and the cut end surface (1b) and expose a portion of the electrode (2, 2a) from the inclined surface (4) before cutting the unit substrate (1) along the predetermined cutting lines; and
   cutting the unit substrate (1) along the cutting lines to leave at least the portion of the inclined surface (4) where the electrode (2, 2a) is exposed.

3. A method of manufacturing an electronic part in which a unit substrate (1) having an electrode arrangement surface coated with a coating material (3) is cut along predetermined cutting lines to obtain an electronic part element having an electrode (2, 2a) exposed from the cut end surface, the method comprising the steps of:

cutting the unit substrate (1) along the cutting lines; and

forming an inclined surface (4) in the boundary (1c) of the unit substrate (1) between the electrode arrangement surface (1a) and the cut end surface (1b) thereof by using a blade (11) having a shape in which a portion thereof butted against the boundary (1c) of the unit substrate (1) between the electrode arrangement surface (1a) and the cut end surface (1b) thereof is inclined at a predetermined angle to expose a portion of the electrode (2, 2a) from the inclined surface (4).

4. A method of manufacturing an electronic part according to Claim 1, 2 or 3, wherein the unit substrate (1) is cut by using a dicing blade (13).

5. A method of manufacturing an electronic part according to Claim 1, 2, 3 or 4, wherein the dicing blade (11) used has a substantially disk shape comprising a thin portion (17) having a small thickness and formed in the outer peripheral side outside the predetermined position in the radial direction, a thick portion (18) having a larger thickness than the thin portion (17) and formed nearer the central side than the thin portion (17), and an inclined portion (19) formed in the boundary between the thin portion (17) and the thick portion (18), so that the unit substrate (1) is cut by the thin portion (17), and the boundary (1c) of the unit substrate (1) or a portion which becomes the boundary (1c) is cut by the inclined portion (19) of the blade (11) to form an inclined surface (4) in the boundary (1c).

6. A method of manufacturing an electronic part in which a unit substrate (1) having an electrode arrangement surface coated with a coating material (3) is cut along predetermined cutting lines to obtain an electronic part element having an electrode (2, 2a) exposed from the cut end surface, the method comprising the steps of:

forming a groove in the surface of the unit substrate (1) along the predetermined cutting lines by using a blade (11) having a shape in which the central portion of the outer peripheral surface in the thickness direction projects so that the projecting central tip (21) functions as a break groove forming portion for forming a break groove (12a) in the unit substrate (1), for breaking the unit substrate (1), and the adjacent inclined portion (23) adjacent to the central tip (21) functions as an inclined surface forming portion for cutting a portion of the unit substrate (1) which becomes the boundary (1c) between the electrode arrangement surface (1a) and the cut end surface (1b) thereof to form an inclined surface (4) in the portion of the unit substrate (1) which becomes the boundary (1c), and in which the angle θ1 formed by two surfaces of the central tip (21) is smaller than the angle θ2 formed by two surfaces of the inclined surface forming portion (23), to form the break groove (12a) in the surface of the unit substrate (1) and, at the same time, form an inclined surface (4) in the portion which becomes the electrode arrangement surface and the cut end surface; and

breaking the unit substrate (1) along the break groove (12a) to obtain an element in which a portion of the electrode (2, 2a) is exposed from the inclined surface (4).

7. A method of manufacturing an electronic part according to any one of Claims 1 to 6, wherein the blade (11) used comprises an inner member (15) having a tip projecting so as to contact the unit substrate (1) earlier than other portions, and an outer member (16) holding the inner member (15) from the both sides thereof, wherein the inner member (15) is made of a material suitable for cutting the unit substrate (1), and the outer member (16) is made of a material suitable for cutting the coating material (3).

8. An electronic part comprising:

a rectangular element having an upper side (1a), a lower side and four sides (1b) connecting to the upper and lower sides;

a conductor pattern (2, 2a) buried in the rectangular element;

an external terminal electrode connected to an exposed portion of the conductor pattern (2, 2a) which is exposed from at least one side of the rectangular element; and

a chamfer inclined surface (4) formed in the boundary (1c) between the upper side (1a) and each of the four sides (1b) of the rectangular element so that the conductor pattern (2, 2a) is led out to the inclined surface (4), and the exposed portion of the conductor pattern (2, 2a) is inclined along the inclined surface (4).

FIG. 1A
(a)

FIG. 1B
(b)

CUTTING LINE

FIG. 2

FIG. 3

FIG. 4

FIG. 5

FIG. 6

14

FIG. 7

FIG. 8

FIG. 9

FIG. 10

FIG. 11A
(a)

52    51(58)    D

53    C

FIG. 11B
(b)

52    51

D

C

53

FIG. 12

European Patent
Office

**EUROPEAN SEARCH REPORT**

Application Number

EP 98 40 1397

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 5 600 101 A (SAKAI NORIO) 4 February 1997 | 1-4,8 | H01L21/78 H01L21/48 |
| A | * column 5, line 5 - column 35; figures 3,4 * | 5,6 | H01F41/04 H01F27/29 |
| | --- | | |
| A | PATENT ABSTRACTS OF JAPAN vol. 009, no. 212 (E-339), 29 August 1985 & JP 60 074642 A (NIPPON DENKI KK), 26 April 1985 * abstract * | 5,6 | |
| | --- | | |
| A | DE 43 06 655 A (TOSHIBA KAWASAKI KK) 9 September 1993 | | |
| | ----- | | |

**TECHNICAL FIELDS SEARCHED (Int.Cl.6)**

H01L
H01F

The present search report has been drawn up for all claims

| Place of search | Date of completion of the search | Examiner |
|---|---|---|
| THE HAGUE | 30 September 1998 | Marti Almeda, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)